# EUROPÄISCHE PATENTSCHRIFT

(11) **EP 0 742 959 B1**
(45) Veröffentlichungstag und Bekanntmachung des Hinweises auf die Patenterteilung: **14.11.2001**
(21) Anmeldenummer: 94921594.1
(22) Anmeldetag: 25.07.1994
(51) Int. Cl.: H01L 31/0236, H01L 31/068

(54) **Verfahren zur Herstellung einer Solarzelle, sowie nach diesem verfahren hergestellte Solarzelle**
Method of producing a solar cell and solar cell produced using this method
Méthode de fabrication d'une cellule solaire et cellule solaire ainsi produite

(30) Priorität: 29.07.1993 DE 4325407
(43) Veröffentlichungstag der Anmeldung: 20.11.1996
(60) Teilanmeldung: 00126819.2
(73) Patentinhaber: Willeke, Gerhard, D-78534 Konstanz (DE); Fath, Peter, D-88709 Meersburg (DE)
(72) Erfinder: Willeke, Gerhard, D-78534 Konstanz (DE); Fath, Peter, D-88709 Meersburg (DE)
(74) Vertreter: Pietruk, Claus Peter, Dipl.-Phys.
(86) Internationale Anmeldenummer: DE9400860
(87) Internationale Veröffentlichungsnummer: WO9505008

(56) Entgegenhaltungen:
- EP-A- 0 548 863
- DE-A- 4 033 658
- FR-A- 2 489 597
- US-A- 2 911 539
- US-A- 4 227 942
- US-A- 4 608 451
- IBM TECHNICAL DISCLOSURE BULLETIN., Bd.21, Nr.6, November 1978, NEW YORK US Seiten 2585 - 2586 T.S. KUAN ET AL. 'Two-sided groove etching method to produce silicon ink jet nozzles'
- APPLIED PHYSICS LETTERS., Bd.62, Nr.23, 7. Juni 1993, NEW YORK US Seiten 2941 - 2943 H. BENDER ET AL. 'Polycrystalline silicon solar cells with a mechanically formed texturization'
- APPLIED PHYSICS LETTERS., Bd.64, Nr.10, 7. März 1994, NEW YORK US Seiten 1274 - 1276 G. WILLEKE ET AL. 'Mechanical wafer engineering for semitransparent polycrystalline silicon solar cells'
- 12TH EUROPEAN PHOTOVOLTAIC SOLAR ENERGY CONFERENCE, 11. April 1994, AMSTERDAM, NL Seiten 766 - 768 G.WILLEKE ET AL. 'The POWER silicon solar cell concept'
- A. TAKEOKA ET AL.: "Development and application of see-through a-Si solar cells", SOLAR ENERGY MATERIALS AND SOLAR CELLS, AMSTERDAM, 01. April 1993, Band 29, Nr. 3, Seiten 243 - 252

## Beschreibung

Die Erfindung betrifft ein Verfahren zur Herstellung einer solarzelle mit einem Gitternetz von Durchgangslöchern sowie eine nach diesem Verfahren hergestellte Solarzelle.

In vielen Bereichen der Technik kommen Bauelemente zum Einsatz, die eine regelmäßige Anordnung von Durchgangslöchern aufweisen. Dabei dienen die Löcher als Durchlaßöffnungen für Gas- und Flüssigkeitsströme (Filter- und Strömungstechnik sowie Sensorik), geladene Teilchen (Ionen- oder Elektronenoptiken) und elektromagentische Strahlung (IR- und VIS Optik) oder zur elektrischen Verbindung zwischen der Vorder- und Rückseite einer Halbleiterscheibe (Mikroelektronik und Photovoltaik). Zur Erzeugung einer regelmäßigen Anordnung von Löchern in einem scheibenartigen Grundkörper kommen gegenwärtig verschieden Verfahren zum Einsatz, je nach vorliegenden Material und Abmessungen der zu erzeugenden Öffnungen. Liegen die Durchmesser der Löcher im Millimeterbereich und größer so werden mechanische Verfahren wie Bohren oder Fräsen verwendet. Mit Hilfe von Funkenerosion können Löcher in leitenden Materialien bis in den 100µm Bereich erzeugt werden. Zur Herstellung von Löchern in Metallen, Keramiken und Halbleitern mit Abmessungen von 10µm und größer kommen feinfokussierte gepulste Laser zum Einsatz. Mit Öffnungen in der gleichen Größenordnung lassen sich Gitter direkt durch galvanisches oder stromloses Abscheiden von Metallen auf mit entsprechenden Masken versehenen Grundkorpern erzeugen oder durch Pressen oder Walzen von duktilen Metall- oder Kunststoffolien auf Formkorpern mit dem dazugehörigen Negativprofil. Speziell bei Vorliegen von spröden Materialien wie Keramiken und Halbleitern kann auf Ultraschallbohren zurückgegriffen werden. Zur Erzeugung von Löchern im µm und sub-µm Bereich in Metallen und Halbleitern sind photolithographische Methoden in Kombination mit Ätztechniken besonders geeignet.

Aus der US-A- 2,911,539 ist bereits ein Photozellenarray bekannt, welches verwendet wird, um zweidimensionale Lichtmuster zu analysieren. Es umfasst eine Vielzahl von Zellen, die in einem zweidimensionalen Feld angeordnet sind, wobei jede Zelle eine intermediäre Zone eines Leitfähigkeitstypus zwischen Oberflächenzonen des entgegengesetzten Leitähigkeitstypus umfasst, um ein Paar von gleichrichtenden Übergängen in jeder der Zellen zu bilden. Eine solche Anordnung ist aufgrund der zwei gleichrichtenden Übergänge nicht geeignet, bei Lichteinfall Leistung bereitzustellen.

Aus dem Aufsatz "Development and application of see-through a-Si solar cells" von A. Takeoka et al., Solar Energy Materials and Solar Cells 29, 1993, Seiten 243-252 ist eine durchscheindende Solarzelle aus amorphen Silicium bekannt, welche eine Vielzahl mikroskopischer Löcher innerhalb ihrer effektiven Fläche aufweist, um Licht durchzulassen und elektrische Leistung zu erzeugen. Derartige Solarzelle wurden auf dem Dach eines Autos eingesetzt, um das Lüftungssystem des Autos zu betreiben oder die Batterie zu laden, wodurch die Innentemperatur am Tag von 61 auf 47° während des Parkens verringert werden konnte.

Aufgabe des vorliegenden Erfindung ist daher die Bereitstellung eines Verfahrens zur Herstellung von Solarzellen aus Kristallinem Silizium, die Gitternetze mit regelmäßig angeordneten Durchgangslöchern aufweisen, bei dem im Vergleich zu bisherigen Methoden eine große Vielfalt bzgl. Gitteraufbau und Variation des Durchmessers der Durchgangslöcher gewährleistet ist.

Diese Aufgabe wird bei einem Verfahren nach Anspruch 1 gelöst.

Mit dem erfindungsgemäßen Verfahren lassen sich Solarzellen nach Anspruch 14 herstellen. Der Abstand der Gräben untereinander, der Winkel, den die Gräben einer Seite untereinander sowie die Gräben der Vorder- und Rückseite relativ zueinander einschließen, die Grabenform und Grabentiefe bestimmen den prinzipiellen Aufbau des Gitters und legen insbesondere die Anordnung, Form und Größe der Löcher fest.

Bei einer bevorzugten Ausführungsform werden die Gräben mechanisch, insbesondere mittels eines schnell rotierenden, mit angeschrägten Profilen versehenen Sägeblattes, in den Grundkörper eingebracht. Dieses Verfahren ist vor allem im Hinblick auf die Universalität der bearbeitbaren Materialien und die mögliche Vielfalt bei der Ausgestaltung von Gräben und Durchgangslöcher und damit der Gitternetzstrukturen von Vorteil. Die hohe Genauigkeit bei der Anwendung von Sägemaschinen gewährleistet die Herstellung von Gitter mit entsprechend hoher Präzision. Durchmesser der Durchgangslöcher von bis zu 5µm sind speziell bei Verwendung angeschrägter Sägeblätter möglich, wobei der minimale Lochdurchmesser lediglich durch die Korngröße des Abriebmittels der Sägeblätter begrenzt wird. Durch die Montage mehrerer Sägeblatter auf einer Spindel kann der Produktionsdurchsatz gesteigert werden.

Die Gräben können auch mit einem anderen mechanischen Verfahren, insbesondere mittels eines schnell rotierenden Sägeformkörpers eingebracht werden. Der Sägeformkörper besteht in diesem Fall aus einem walzenförmigen Grundkörper, der das Negativprofil der Gräben aufweist und mit einem Abriebmittel überzogen ist. Die Verwendung einer solchen Strukturierwalze ermöglicht einen hohen Produktionsdurchsatz von Gittern, und hat die Vorteile der einfachen Montage und der relativ geringen Kosten im Vergleich zu Sägeblättern. Der walzenförmigen Grundkörper kann aus Metall (z.B. weiche Stähle, Aluminium, Bronze, usw.) bestehen, es sind aber auch andere Materialien, insbesondere Keramiken und Spezialkunststoffe denkbar. Schließlich ist auch eine direkte Herstellung einer Strukturwalze aus dem entsprechenden Abriebmittel, beispielsweise Nickel/Diamant, Bornitrid, Siliziumcarbid, usw., denkbar.

Die Erfindung betrifft auch die Verwendung der erfindungsgemäßen Solarzelle als Hochleistungssolarzelle. Zu diesem Zweck ist die erfindungsgemäße Solarzelle auf der Grundlage einer kristallinen Siliziumscheibe hergestellt und weist auf der Vorder- und Rückseite mit Ausnahme der Kontaktzonen eine ganzflächig ausgebildete Emitterbeschichtung auf, wobei die Emitterschicht der Vorderseite mit der Emitterschicht der Rückseite über die Durchgangslöcher in elektrischer Verbindung steht.

Bei Verwendung von multikristallinen Siliziumscheiben als Ausgangsmaterial zur photovoltaischen Energiegewinnung sind die üblicherweise relativ geringe Diffusionslänge der Minoritätsladungsträger sowie der kleine Absorptionskoeffizient des Siliziums Hindernisse zur Erzielung eines hohen Wirkungsgrades. Insbesondere bei den modernen kostengünstigen Plattengießverfahren werden verfahrenstechnisch bedingt nur relativ kleine Kristallitgrößen und somit Diffusionslängen erreicht.
Um die beiden Hauptursachen der kleinen Diffusionslänge der Minoritätsladungsträger, Rekombination an Korngrenzen und Verunreinigungen, zu mindern, werden die multikristallinen Si-Substrate im Verlauf des Solarzellenproduktionsprozesses einer Behandlung mit Wasserstoff und/oder eines Phosphorgetterschrittes unterzogen [1], [2]. Die erzielten Ergebnisse sind aber in der Regel beschränkt. Deshalb wird hauptsächlich versucht, durch Verbesserung des üblichen Blockgußverfahrens möglichst grobkristallines, reines Material zu bekommen.

Um das Problem des kleinen Absorptionskoeffizients von Silizium zu lösen, wurden in der Vergangenheit verschiedene Verfahren zur besseren Einkopplung des einfallenden Lichtes entwickelt.
Derzeit finden neben dem Auftragen von Antireflex-Beschichtungen vor allem Methoden Anwendung, bei denen die Oberfläche des Siliziumsausgangsmaterials strukturiert wird.
Bei monokristallinem Silizium werden unter Zuhilfenahme des anisotropen Ätzverhaltens organischer sowie alkalischer Ätzlösungen und gegebenenfalls in Kombination mit vorausgehenden photolithographischen Verfahrensschritten unregelmäßig verteilte Pyramiden, geordnete Muster aus invertierten Pyramiden [3], lamellenartige Strukturen [4] oder V-förmige Gräben [5] erzeugt.
Aufgrund der unregelmäßigen Verteilung von Kristalliten verschiedenster Kristallorientierung in multikristallinen Siliziumscheiben zeigen die genannten Verfahren nur sehr unbefriedigende Resultate. Als alternative Strukturierungsmethoden wurden nach dem Stand der Technik Oberflächentexturierungen mit Hilfe von Lasern [6] oder konventionellen Siliziumwafer-Sägen, bestückt mit unangeschrägten oder angeschrägten Trenn-Sägeblättern [7] [8] durchgeführt. Die Oberflächentextur wurde jeweils auf der dem Sonnenlicht zugewandten Seite der Solarzelle durchgeführt.

Mit dem erfindungsgemäßen Bauelement ist es erstmals möglich, eine Hochleistungssolarzellen aus kristallinen, insbesondere feinkristallinen direkt gegossenen Siliziumscheiben bereitzustellen, und zwar trotz der relativ kleinen Diffusionslänge der Minoritätsladungsträger in multikristallinem Silizium und des kleinen Absorptionskoeffizients in diesen Materialien. Es kann eine Hochleistungssolarzelle hergestellt werden
- aus monokristallinen Siliziumscheiben sowie aus multikristallinem Siliziumausgangsmaterial von strukturell und elektronisch minderer Qualität,
- mit einem einfachen Herstellungsverfahren unter Zuhilfenahme eines schnell rotierenden Säge-Formkörpers, ausgestattet mit spitz zulaufenden Profilen, und nur wenigen folgenden Prozeßschritten,
- mit hohem Wirkungsgrad bei der photovoltaischen Energieumwandlung,
- mit Lichtempfindlichkeit beider Seiten der Zelle,
- bei niedrigem Gewicht,
wobei die erhaltene Solarzelle steuerbar lichtdurchlässig ist.

Aufgrund der genannten Vorteile ist die erfindungsgemäße Hochleistungssolarzelle aus kristallinen Siliziumscheiben fiir einen großflächigen terrestrischen Einsatz bestens geeignet Interessant erscheint außerdem eine mögliche Anwendung dieser Technologie auf monokristallinem Silizium fiir den extraterrestrischen Gebrauch unter besonderer Berücksichtigung des Gewichtsvorteils und der zu erwartenden guten Strahlungstoleranz. Weitere spezielle Einsatzgebiete ergeben sich bei Ausnutzung der durch die Lochgröße regelbaren Lichttransparenz. So kann die Solarzelle sowohl bei Fensterabdeckungen im Geschäftsbereich und im privaten Sektor als auch in Sonnendächern von Kraftfahrzeugen eingesetzt werden oder als integraler Baustein von Fassadenverkleidungen dienen.

Bei einer bevorzugten Ausführungsform der erfindungsgemäßen Hochleistungssolarzelle sind die Oberfläche(n) der Solarzelle ganzflächig, mit Ausnahme der Kontaktzonen passiviert.

Die Stege zwischen den Gräben können in alternierender Reihenfolge mit einer n⁺⁺- bzw. p⁺⁺-Diffusion versehen sein.

Bei einer besonders vorteilhaften Variante der Solarzelle sind die Gräben auf der Rückseite der Solarzelle derart angeordnet, daß sie alternierend an ihrem einen bzw. anderen Ende mit dem jeweils benachbarten Graben eine spitzen Winkel einschließen, so daß ein durchgängiger Graben mit einem Zick-Zack-Verlauf ausgebildet ist und die dazwischen befindlichen Stege an ihrem dem Grabenwinkel zugewandten Ende spitz zulaufen. Bei Durchführung einer Kontaktfingerdiffusionen, bei der die lateral spitz zulaufenden Siliziumstege einer Seite mit einer n⁺⁺-Diffusion und die Stege der gegenüberliegenden Seite mit einer p++-Diffusion versehen werden, wird eine für Rückkontakt-Solarzellen vorteilhafte Kontaktfingeranordnung von ineinander verzahnten Kontakten alternierenden Ladungsträgertypes (n++-p++-n++) erzielt.

An dem (jeweils) äußeren Rand der Rückseite der Solarzelle kann eine Hauptleiterbahn ausgebildet sein, wodurch die elektrische Verbindung von einzelnen Konataktfingern gleichen Ladungsträgertypes, insbesondere bei der vorliegenden Kontaktfingeranordnung, stark vereinfacht wird.

Mit dem oben genannten Kontaktierungsschema ist es möglich, Rückkontakt-Solarzellen auf einfache Art und Weise herzustellen, bei denen sich die stromabführenden Metallkontakte vollständig auf der Rückseite befinden. Diese Anordnung hat den Vorteil des Nichtauftretens von Reflexionsverlusten im Vergleich zu einer Zellmetallisierung auf der Vorderseite.

Die Erfindung betrifft auch ein Verfahren zur Kontaktierung der erfindungsgemäßen Solarzelle, das dadurch charakterisiert ist, daß die zwischen den Gräben verlaufenden, herausragenden Stege metallisiert werden.

Vorzugsweise beinhaltet dieses Verfahren, daß ein walzenartiger Körper, der mit einer metallhaltigen Paste überzogen ist, über die herausragenden Stege gerollt wird.
Mit diesem Walzendruckverfahren können darüberhinaus dotandenhaltige Pasten zur selektiven Kontaktdiffusion (n++ und p++) sowie Ätzmittel zur selektiven Öffnung eines Passivierungsoxids oder -nitrids aufgetragen werden.

Bei einer besonders bevorzugten Variante des erfindungsgemäßen Kontaktierungsverfahrens wird ein photosensitiver Lack aufgebracht, dieser Lack unter einem vorzugsweise kleinen Winkel schräg belichtet, nachfolgend der belichtete Lack entfernt, und anschließend innerhalb der dadurch erzeugten Öffnungen an der Oberseite der Gräben eine Metallisierung vorgenommen.

Vor der Metallisierung der Kontaktbahnen sollte eine starke n-Typ bzw. p-Typ Diffusion in den Bereichen der Kontaktbahnen vorgenommen werden.

Falls gewünscht oder gar notwendig, können die metallisierten Kontaktbahnen auch ausschließlich auf der Rückseite der Solarzellen ausgebildet sein.

Die Erfindung wird im folgenden anhand von Ausführungsbeispielen, die teilweise in den Zeichnungen dargestellt sind, näher erläutert. Es zeigen
- Fig. 1:: ein Trennsägeblatt mit abgeflachtem Profil und einem Spiewinkel,
- Fig. 2:: Schnittzeichnungen zweier Strukturwalzengrundkörper
- Fig. 3:: eine Darstellung des Walzenstrukturierungsverfahrens
- Fig. 4:: eine Strukturwalze mit unprofiliertem, glatten Grundkörper
- Fig. 5:: eine perspektivische Schnittzeichnung einer fertig prozessierten Solarzelle gemäß Ausführungsvariante I
- Fig. 6:: eine Aufsicht auf einen Ausschnitt einer Solarzelle gemäß Ausführungsvariante I
- Fig. 7:: Querschnitt durch eine Solarzelle gemäß Ausführungsvariante I in Schnittrichtung A-B von Fig. 6
- Fig. 8:: eine perspektivische Schnittzeichnung einer fertig prozessierten Solarzelle gemäß Ausführungsvariante II
- Fig. 9:: eine Aufsicht auf einen Ausschnitt einer Solarzelle gemäß Ausführungsvariante II
- Fig. 10 :: Querschnitt durch eine Solarzelle gemäß Ausführungsvariante II in Schnittrichtung A-B von Fig. 9
- Fig. 11:: Aufsicht auf die Rückseite einer Solarzelle gemäß Ausführungsvariante III,
- Fig. 12:: Darstellung des Walzendruckverfahrens zur Kontaktfingermetallisierung,
- Fig. 13:: eine perspektivische Zeichnung des beschriebenen Belichtungsvorganges,
- Fig. 14:: eine perspektivische Zeichnung des dargestellten Metallaufdampfprozesses,
- Fig. 15: eine Prinzipdarstellung zur Erläuterung der Einkopplung von Photonen in eine Solarzelle nach den Figuren 5...14.

### Beispiel 1

### Herstellung des erfindungsgemäßen Bauelements mit Gitter

Bringt man in den scheibenförmigen Grundkörper äquidistante, parallel zueinander verlaufende Gräben 8 ein, wobei die Gräben 8 der Vorder- und Rückseite einen Winkel von 90° einschließen und den gleichen Abstand untereinander aufweisen, so erhält man ein Gitternetz mit quadratischer Einheitszelle der Löcher 7. Unterscheiden sich der Abstand der Gräben 8 auf der Vorder- und Rückseite, so ist die Einheitszelle rechtwinkeliger Natur. Schließen die Gräben 8 beider Seiten einen Winkel ungleich 90° ein, so erhält man als Grundelemente des Gitters Parallelogramme. Läßt man die Gräben 8 einer oder beider Seiten einen Winkel zueinander einschließen, so kann man neben Trapezen oder Dreiecken als Einheitszellen weitgehend beliebige Anordnungen von Löchern innerhalb des Gitternetzes erzeugen. Die Größe und Form der Löcher 7 wird bei Vorliegen einer rechtwinkeligen Grabenform direkt durch die Breite der Gräben 8 der Vorder- und Rückseite festgelegt. Gräben 8 gleicher Breite auf beiden Seiten des scheibenförmigen Grundkörpers generieren an ihren Kreuzungspunkten quadratische Löcher 7 mit der Grabenbreite als Kantenlänge. Bei unterschiedlicher Grabenbreite erzeugt man rechtwinkelige Lochformen. Verwendet man V-förmige Grabenprofile, so erhält man rautenförmige Löcher 7, deren Größe mit der Tiefe der Gräben 8 auf Vorder- und Rückseite zunimmt. Verrundete Grabenprofile ermöglichen runde Lochformen. Der Bedeckungsgrad der Lochfläche relativ zur Gesamtscheibenfläche kann durch den Grabenabstand und durch die Lochgröße über weite Bereiche je nach Anwendung beliebig eingestellt, wobei eine obere Grenze lediglich durch die erforderliche mechanische Stabilität des Bauelementes vorgegeben wird.

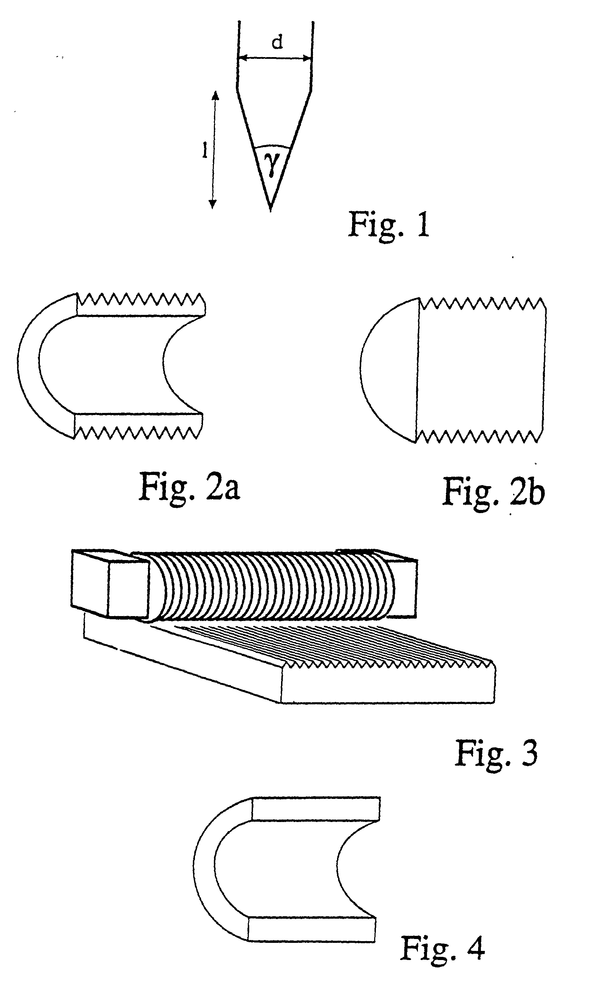

Mögliche Verfahren zur Erzeugung der Gräben 8 richten sich nach der Art der verwendeten Materialien und den Abmessungen der zu erzeugenden Gitternetze:
a) Auf Metalle und Halbleiter gleichermaßen gut anwendbar ist das Einbringen der Gräben 8 mit Hilfe von Lasern im ungepulsten Betrieb. Dadurch können Gräben 8 mit minimalen Breiten im Bereich von 10µm erzeugt werden.
b) Bei Verwendung von monokristallinen Halbleitermaterialien, insbesondere Silizium, als Grundmaterial des Gitters können unter Ausnutzung des anisotropen Ätzverhaltens alkalischer und organischer Ätzmittel und unter Einbeziehung photolithographischer Arbeitsschritte Gräben 8 speziell mit V-Profil in den scheibenförmigen Grundkörper eingearbeitet werden.
c) Bei der mechanischen Einarbeitung unter Verwendung schnell rotierender Sägeformkörper werden kommerziell erhältliche scheibenförmige Sägeblätter auf einer schnell rotierenden Spindel, vorzugsweise einer automatischen Präzisionssägemaschine, montiert. Arbeitet man im Einblattbetrieb, werden die zur Herstellung eines Gitters erforderlichen Gräben 8 Schnitt für Schnitt durch Scannen des mit bis zu 30000U/min rotierenden Sägeblattes mit konstanter Vorschubgeschwindigkeit über den Scheibengrundkörper eingebracht. Mit gegenwärtig kommerziell erhältlichen Sägemaschinen sind minimale Schnittiefen und Schnittabstände bis 0,1µm mit einer Wiederholungsgenauigkeit von 1µm möglich. Der Winkel, den zwei aufeinanderfolgende Schnitte einschließen können, kann zwischen 0° und 90° mit einer Genauigkeit 0.001° eingestellt werden. Die Vorschubgeschwindigkeit des Sägeblattes während des Scanvorganges kann bis zu 300mm/s betragen. Materialien, zu deren Bearbeitung gegenwärtig Sägeblätter angeboten werden, fallen in die große Klasse der kurzspanenden Werkstoffe. Dies sind alle gängigen Halbleitermaterialien, insbesondere Silizium, Keramiken, Ferrite, Gläser, Edelsteine und alle kurzspanenden Metalle wie Molybdän, Titan, usw.. Ferner werden neben Trennsägeblättern mit abgeflachtem Profil (Spitzenwinkel (siehe Abb. 1): 180°) V-Förmig angespitzt Sägeblätter angeboten, wobei deren Spitzenwinkel über einen weiten Winkelbereich frei wählbar ist. Die kommerziell erhältlichen Trennsägeblätter haben minimale Dicken bis 7µm, während gegenwärtig profilierte Sägeblätter mit Dicken bis minimal 100µm erwerbbar sind. Zur Steigerung des Durchsatzes bei der Herstellung wird das Mehrblattverfahren angewendet, bei dem bis zu 100 Sägeblätter auf einer Spindel montiert sind.
d) Bei Durchführung des Verfahrens mittels Strukturierungswalzen wird ein walzenartiger Grundkörper optional mittels feinmechanischer Methoden über den gesamten Umfang und die ganze Walzenlänge mit dem Negativprofil der späteren Gitterstruktur versehen und anschließend mit Schleifmittelkörnern (z.B. bestehend aus Diamant, Bornitrid, Siliziumcarbid, usw.) überzogen. Als Ausgangsmaterial für den Grundkörper eignen sich Metalle (z.B. weiche Stähle, Aluminium, Bronze, usw.) aber auch Keramiken und Spezialkunststoffe. Eine direkte Herstellung der Strukturwalze aus dem entsprechenden Abriebmittel ist ebenfalls möglich.

Fig. 2 zeigt Schnittzeichnungen einer Strukturwalze mit einem Negativprofil, bestehend aus V-förmigen Rillen. Die Strukturwalze nach Fig. 2a kann auf dem Flansch einer schnell rotierenden Spindel montiert werden. Eine Strukturwalze mit einem massiven Grundkörper gemäß Fig. 2b wäre direkt über zwei Aufhängungspunkten mit der Antriebseinheit eines schnell rotierenden Motors zu verbinden. Zur Erzeugung der V-förmigen Rillen bzw. der Negativprofile in den Strukturwalzen allgemein bietet sich das von Bier et al. [KFK-Nachr. Jahrg. 23 2-3/91, S. 165-173] entwickelte Diamantfräsverfahren zur mikromechanischen Bearbeitung von Metallkörpern an, bei dem mit Hilfe eines hoch präzise geschliffenen Diamanten, der auf einem CNC gesteuerten XYZ-Tisch montiert ist, in einen schnell rotierenden Metallkörper Strukturen im Bereich von bis zu minimal 10µm eingefräst werden. Die so profilierte Metallwalze wird anschließend mit Schleifmittelkörner beschichtet. Dies kann unter Anwendung kommerzieller Technik auf elektrochemischen Wege geschehen, wobei eine mehrere zehn Mikrometer dicke Schicht bestehend aus Diamantpulver, welches in einer Bindemittelmatrix (z.B. Nickel) eingebettet ist, aufgetragen wird. Eine Beschichtung mittels Sinterverfahren ist ebenfalls denkbar. Auf eine schnell rotierende Spindel gespannt, könnte man mit einer entsprechend langen Strukturierungswalze in einem einzigen Arbeitsschritt eine Seite eines Gitters strukturiert werden, wie schematisch in Fig. 3 dargestellt.

In Fig. 4 ist eine Strukturwalze dargestellt, die aus einem unprofilienen, glatten Metallgrundkörper besteht, der mit einer Schleifmittelschicht überzogen ist. Diese Art Strukturwalze ist besonders zur Bearbeitung von kostengünstigen bandgegossenen Siliziumscheiben geeignet.
Bei Verwendung derartig hergestellter Silziumscheiben bzw. -bänder (z.B. Bayer RGS oder S-Web Silizium) für die industrielle Solarzellenproduktion treten Probleme aufgrund der relativ unebenen Oberfläche und der Oberflächenbeschaffenheit (Kontamination oberflächennaher Schichten mit Verunreinigungen und relativ dicke Siliziumoxidschichten an der Oberseite der Scheiben) auf. Führt man die mechanischen Strukturierung mit einer unprofilierten Walze aus, so wird eine Planarisierung der Oberfläche bei gleichzeitiger Entfernung eines Siliziumoxidbelages und kontaminierter oberflächennaher Schichten erzielt. Damit sind die genannten Probleme vermieden und es ist eine Steigerung der Qualität von im Bandgußverfahren hergestellten Siliziumscheiben erreicht.

### Beispiel 2

### Verwendung des erfindungsgemäßen Bauelements als Hochleistungssolarzelle

Nachfolgend werden drei Ausführungsvarianten I, II und III zur Verwendung des erfindungsgemäßen Bauelements als Hochleistungssolarzelle illustriert. Zum besseren Verständnis wird zunächst das Herstellungsverfahren erläutert, das für alle drei Ausführungsvarianten sehr ähnlich ist.

Als Ausgangsmaterial für den Herstellungsprozeß der Solarzelle dienen kristalline Siliziumscheiben (mono-, multi- oder polykristalline), wobei deren Größe, Oberflächenbeschaffenheit und Materialqualität keinen besonderen Anforderungen genügen müssen. Prinzipiell können prozessiert werden:
- monokristalline Siliziumscheiben,
- Wafer, gesägt aus gegossenen Siliziumblöcken,
- multikristalline Silizium-Bänder, hergestellt durch Abscheiden aus einer Siliziumschmelze auf einem Graphitnetz,
- multikristalline Si-Scheiben, die durch Abscheiden von flüssigem Silizium auf Graphitplatten unter Verwendung eines Gießrahmens erhalten werden.

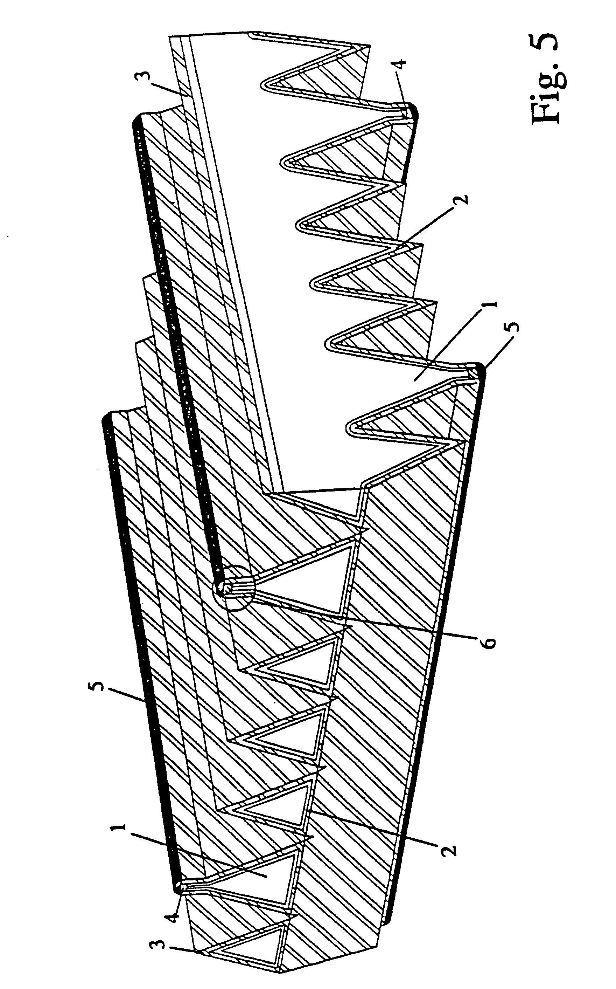

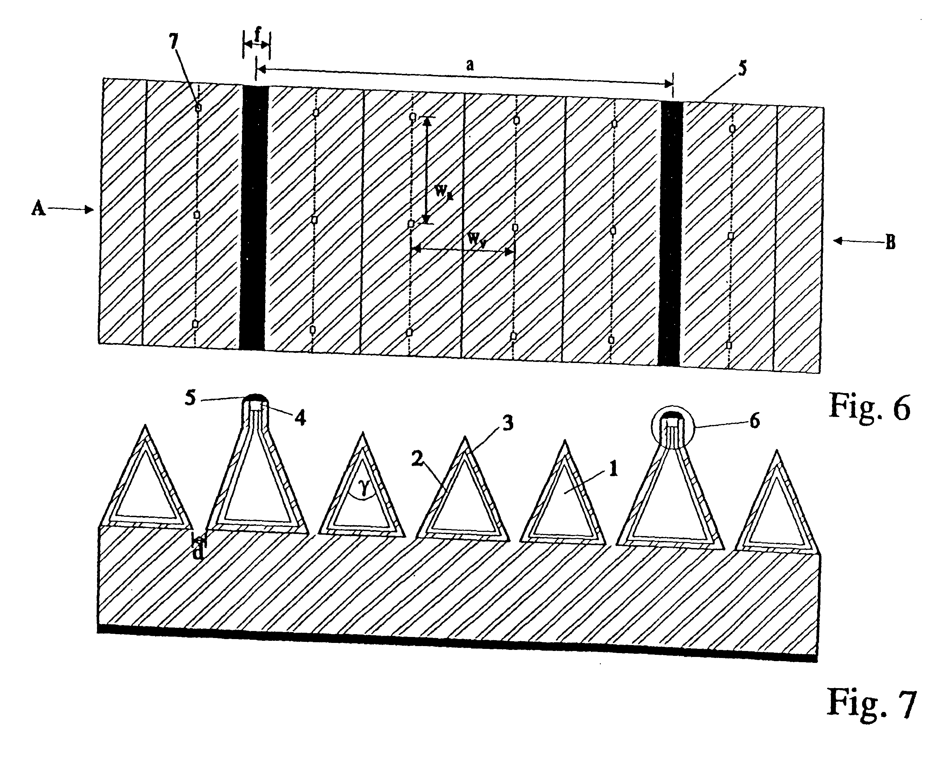

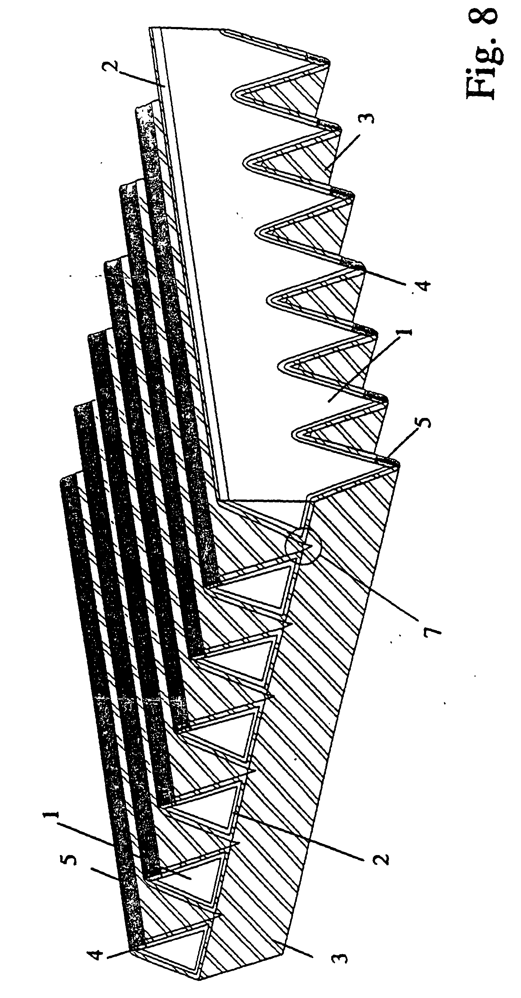

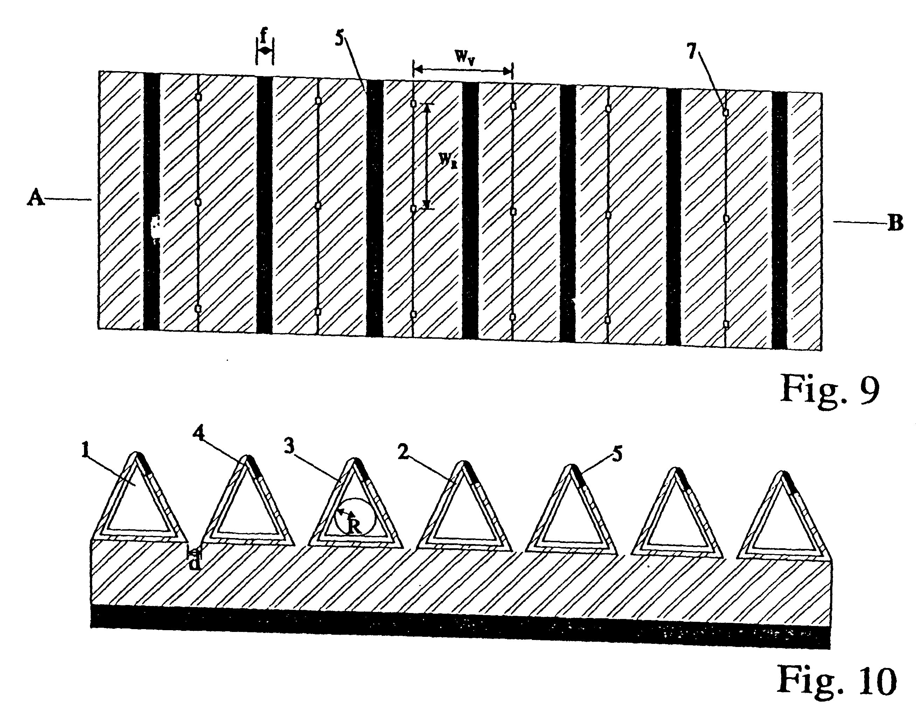

Im ersten Prozeßschritt werden auf beiden Seiten der vorliegenden Siliziumplatte V-förmige, zwischen Vorder- und Rückseite unter einem Winkel zueinander angeordnete Gräben 8 (bevorzugt 90°), mit Hilfe eines schnell rotierenden, mit angeschrägten Profilen versehenen Säge-Formkörpers (z. B. mit spitz zulaufenden Diamantsägeblättern, montiert auf einer konventionellen Siliziumscheibensäge, oder einer Strukturierungswalze) erzeugt. Die Tiefe der Gräben 8 hängt ab von
- der Dicke der zu bearbeitenden Siliziumscheibe,
- den Grabenabständen W_{R} und W_{V} (Fig. 6, Fig. 9) und dem Grabenwinkel GAMMA (Fig.7) und
- der Größe der die Vorder- und Rückseite verbindenden Löcher 7 (Fig. 5-11).

Beispielsweise werden bei 250µm dicken Si-Wafern 80µm dicke Sägeblätter, montiert auf einer Siliziumscheibensäge, mit einem Spitzenwinkel GAMMA von 35° und typischen Grabenabständen W_{R} und W_{V} von ca. 100µm und Grabentiefen von ca. 130µm verwendet.

Um die in den Ausführungsvarianten I und III erforderlichen Siliziumstege 6 zu erzeugen, wird zwischen zwei aufeinanderfolgenden Gräben 8, welche den Steg einschließen, im Vergleich zu den angrenzenden Gräben 8 der Abstand W_{V} bzw. W_{R} vergrößert.

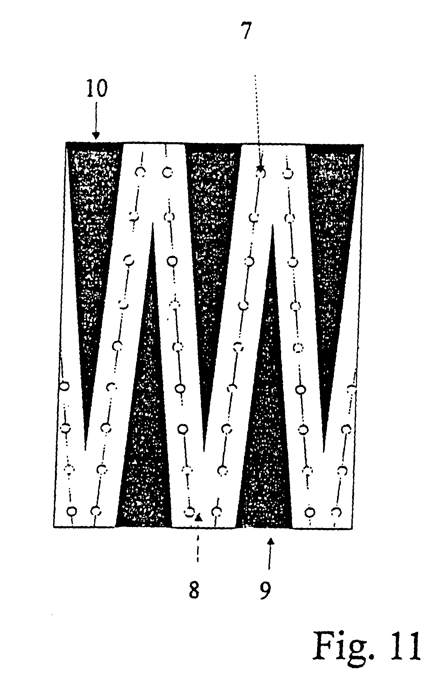

Um die am Ende der Solalzellenprozessierung erforderliche getrennte elektrische Verbindung der n-Typ- und p-Typ- Kontaktfinger 5 in Ausführungsvariante III zu vereinfachen, wird eine Strukturierung der Rückseite der Solarzelle gemäß Fig. 11 vorgeschlagen. Diese Kontaktfingeranordnung wird dadurch erhalten, daß man zunächst parallel zueinander verlaufende V-Gräben 8 einbringt. Anschließend wird in einem folgenden Strukturierungsschritt ein zweiter Satz paralleler Gräben 8 erzeugt, wobei die Richtung der im ersten Strukturierungsschritt erzeugten Gräben 8 einen kleinen Winkel zu den Gräben 8 des zweiten Strukturierungsschrittes einschließt. Bei der in einem der folgenden Prozeßschritte durchgeführten Kontaktfingerdiffusionen werden die lateral spitz zulaufenden Siliziumstege 9 der einen Seite mit einer n⁺⁺ Diffusion versehen und der gegenüberliegende Satz von Stegen 10 mit einer p++ Diffusion. Dadurch wird eine für Rückkontakt-Solarzellen vorteilhafte Kontaktfingeranordnung von ineinander verzahnten Kontakten alternierenden Ladungsträgenypes (n⁺⁺-p⁺⁺-n⁺⁺) erzielt. Ferner wird die elektrische Verbindung der einzelnen Kontaktfinger 5 gleichen Ladungsträgertypes mittels Aufbringen einer Hauptleiterbahn am jeweils äußeren Rand der Rückseite der Solarzelle bei der vorliegenden Kontaktfingeranordnung stark vereinfacht.

Als optionalen, folgenden Verfahrensschritt kann man eine Behandlung des gesägten Si-Substrates in einem sogenannten "damage getter"-Schritt möglicherweise in Verbindung mit Phosphor ("Phosphor-Gettering") durchführen, mit dem in der Einleitung erwähnten Effekt der Steigerung der Minoritätsladungsträger-Diffusionslänge.
Die durch das Herstellen der Gräben 8 im Silizium induzierten Defekte werden in einem anschließenden Ätzschritt entfernt. Mit Hilfe einer Ätzlösung mit polierender Wirkung wird eine von der Korngröße des verwendeten Abriebmittels abhängige typischerweise 10-20µm dicke Schicht auf beiden Seiten der gesägten Siliziumscheibe abgeätzt. Als Ätzmittel kommen sowohl Säuregemische (z.B. Flußsäure HF(50%)-Salpetersäure HNO₃(70%)-Essigsäure CH₃COOH(100%) mit einem Volumenverhältnis von 3:43:7, Ätzdauer 7-13min) in Frage als auch alkalische Lösungen (z.B. KOH- oder NaOH-Lösungen).

Der Emitter 2 der Solarzelle wird ganzflächig durch Phosphordiffusion auf beiden Seiten des Siliziummaterials 1 ( in diesem Fall p-dotiert) erzeugt. Die Bevorzugung von p-leitenden Siliziumscheiben gegenüber n-dotiertem Ausgangsmaterial beruht auf der einfacheren Herstellung sowie besseren Oberflächenpassivierung von diffundierten n-Schichten.
Als folgenden Prozeßschritt schließt sich eine thermische Oxydierung des Siliziummaterials zur Passivierung der Oberflächendefekte an. Von der dabei erhaltenen Oxidschicht 3 kann bei erfolgter Schichtdicken-Optimierung auch ein Antireflexionseffekt erzielt werden. Wahlweise kann der thermischen Oxidation eine ganzflächige Beschichtung mit Nitriden (z.B. SiN) folgen. Man erhält dadurch eine wirksamere Antireflexschicht im Vergleich zum Siliziumoxid und eine effiziente Diffusionsbarriere bei der folgenden starken n- und p-Diffusion für die Emitter- und Basiskontaktregionen.

Zur Kontaktierung der Solarzelle müssen nun die Regionen der Solarzelle von Siliziumoxid/Nitrid befreit werden, die später metallisiert werden sollen.
Diese Kontaktierung kann auf verschieden Art und Weise erfolgen, wie anhand der Ausführungsvarianten I, II und III auszugsweise dargestellt.

Bei Ausführungsvariante I wird dafür das Oxid 3 bzw. die Oxid- und Antireflexschicht auf der Oberseite der herausragenden Siliziumstege 6 entfernt. Dies kann zum einen mittels eines mechanischen Poliervorgangs erfolgen, zum anderen durch Auffüllen der Gräben 8 durch ein ätzresistentes Mittel und anschließendem Entfernen des Oxids 3 (bzw. Nitrids) mit Hilfe von entsprechenden Ätzlösungen geschehen.

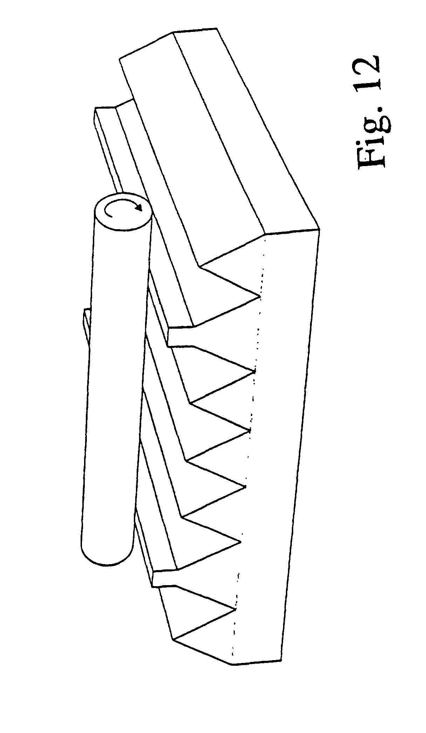

Bei Ausführungsvariante II erfolgt das Öffnen der Kontaktfingerregionen mittels photolithographischer Prozeßschritte. An der Zelle werden anschließend Diffusionsvorgänge mit hoher Dotandenkonzentration durchgeführt, auf der einen Seite eine starke n⁺⁺-Diffusion (selektiver Emitter 2 ) und auf der anderen eine p⁺⁺-Diffusion (Basis). Dabei wird lokal in den von Oxid 3 befreiten Kontaktregionen 4 eine n⁺⁺- bzw. p⁺⁺-Schicht erzeugt, wobei der eigentliche Hochtemperatur-Diffusionsschritt gleichzeitig erfolgen kann. Der Rest der Solarzellenoberfläche ist durch das thermische Oxid 3 oder gegebenenfalls Siliziumnitrid gegen unerwünschte Eindiffusion der Dotanden in den darunterliegenden Emitter 2 geschützt.
Die Fingermetallisierung kann nun durch stromloses Plattieren (z.B. Pd-Ni, Pd-Ni-Cu, Pd-Ni-Ag usw.) hergestellt werden.
Ein weiteres, auf der in Fig. 5 gezeigten Solarzellenstruktur aufbauendes Metallisierungskonzept ist das in Fig. 12 dargestellte Walzendruckverfahren, das der Siebdrucktechnologie sehr verwandt ist. Dabei wird direkt auf die hervorstehenden Siliziumstege 6 unter Verwendung einer Walze (bevorzugt Hartgummi) metallhaltige Paste, die der beim Siebdruck verwendeten entspricht, aufgerollt und entsprechend weiterprozessiert. Vorteilhaft bei diesem Verfahren sind die mögliche Herstellung feinster Kontaktfinger 5, leichte Übertragung auf industrielle Solarzellenprozessierung sowie die Nähe zu der industriell erprobten Siebdrucktechnologie.
Zum Abschluß erfolgt die Verbindung der Kontaktfinger 5 sowie die Zellenverschaltung. Man erhält dies beispielsweise bei Verwendung einer lötfähigen Fingermetallisierung durch Auflöten von Verbinderstreifen, die gleichzeitig den sogenannten "busbar" darstellen.

Die gängigen Methoden zur Erzeugung der Kontaktfingermetallisierung einer kristallinen Solarzelle, nämlich
- das Aufdampfen oder Aufsputtern einer Metallschicht oder einer Schichtenfolge gegebenenfalls in Verbindung mit photolithographischen Prozeßschritten [9],
- das Siebdruckverfahren zum Aufbringen einer mit Metallpartikeln versetzten Paste in Kombination mit einer folgenden Hitzebehandlung [7] und
- das stromlose Plattieren oder galvanische Abscheideverfahren zusammen mit zuvor ausgeführten photolithographischen Verfahrensschritten [11] oder laserunterstützte [6] oder mechanische Erzeugen von in die Zelle eingegrabenen Kontaktbahnen 5 sind nicht oder nur mit großem Aufwand auf die in Ausführungsvariante II vorgestellte Struktur anwendbar.

### Erfindungsgemäß wird daher bei dieser Variante wie folgt verfahren:

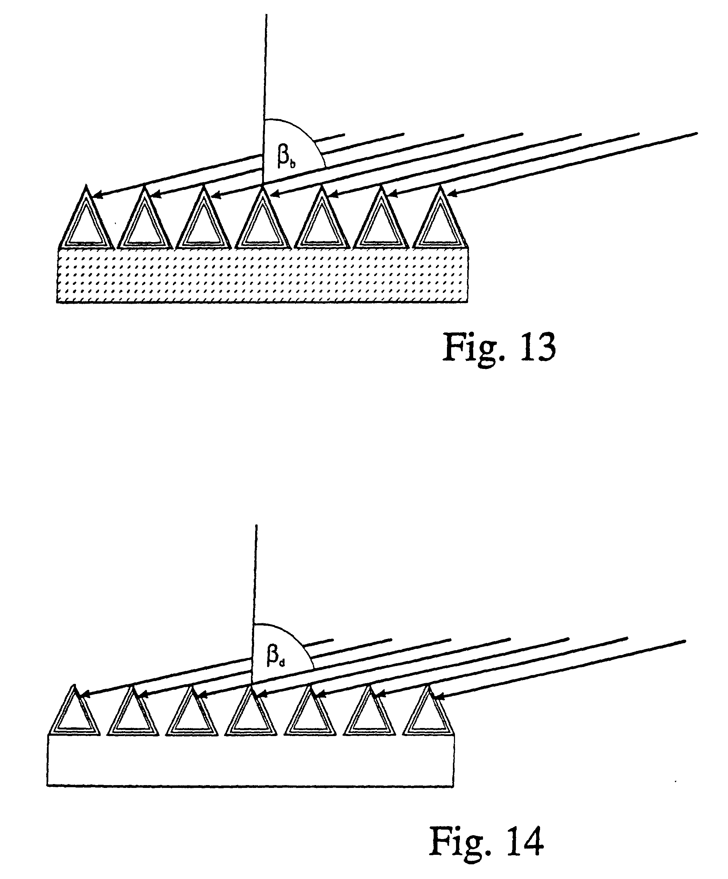

Der Siliziumgrundkörper 1 wird nach den durchgeführten Prozeßschritten des Einbringens der V-förmigen Gräben 8, des Ätzschrittes, der Herstellung des Emitters 2 und der thermischen Oxydation in einem Spin-, Tauch- oder Sprühvorgang mit einer Schicht von Positiv-Photolack überzogen. Die Zugrichtung während des Tauchvorganges sollte, um eine gleichmäßige Benetzung des Siliziumsubstrates zu erhalten, in einem Winkel von 45° zu der Grabenrichtung erfolgen. Nach durchgeführter Trocknung gemäß Herstellerangaben wird die Belichtung nach Fig. 13 in einem Leuchtfeld homogener Intensitätsverteilung vollzogen. Der Winkel (BETA) β_{b} kann je nach gewünschter Breite der Kontaktfinger 5 in einem Bereich zwischen 90-GAMMA/2 (GAMMA/2= halber Grabenspitzenwinkel) und 90° gewählt werden. Der schräge Lichteinfall bewirkt, daß nur ein schmaler Streifen an der Oberseite einer Grabenflanke belichtet wird, da die in Strahlrichtung vorgelagerten Gräben 8 die folgenden beschatten. Den gleichen Belichtungsvorgang hat man auf der gegenüberliegenden Solarzellenseite auszuführen. Die belichtete Fläche des Photolackes wird nun nach Angaben des Herstellers entfernt. Mit dem unbelichteten Photolack als Ätzstop wird dann der Teil der Solarzellenfläche, der später mit Metallen beschichtet werden soll, von thermischem Oxid 3 unter Verwendung von Flußsäure enthaltenden Ätzlösungen befreit. Vor der Fingermetallisierung erfolgt eine selektive Diffusion in der Kontaktzone 4, bei welcher auf einer Seite der Solarzelle ein n⁺⁺-dotierter Kontaktbereich hergestellt wird, auf der gegenüberliegenden ein p++-dotierter Bereich. Anschließend wird nach einem optionalen Ätzschritt die Metallbeschichtung durchgeführt. Zum einen kann dies durch ein Plattierungsverfahren erfolgen, wobei der Effekt der selektiven Abscheidung von Nickel aus wäßrigen Salzlösungen auf von Oxid befreitem Silizium ausgenutzt wird und man somit nur auf den Flächen der Solarzelle Metallabscheidungen erhält, auf denen zuvor das thermische SiO₂ entfernt wurde. Die gewünschte Dicke der Ni-Schicht kann je nach Verweildauer im Plattierungsbad relativ frei gewählt werden. Es ist möglich, der chemischen Vernickelung zum Verbessern der elektrischen Leitfähigkeitseigenschaften der Kontaktfinger 5 einen Kupferplattierungsvorgang oder ein Versilbern der vernickelten Flächen anzuschließen. Als alternatives Metallisierungsverfahren kommt auch Metallaufdampfen in Frage. Der Siliziumgrundkörper 1 ist dabei ähnlich dem Belichtungsvorgang des Photolackes gegenüber der Aufdampfrichtung zu verkippen (Fig. 13). Um eine befriedigende Metallisierung der Kontaktfinger 5 zu erhalten, sollte der Winkel (BETA)β_{d} zwischen der Flächennormale der Solarzelle und der Aufdampfrichtung gleich oder etwas kleiner als der Belichtungswinkel (BETA)β_{b} (Fig. 12) sein. Als weitere Möglichkeit kann eine ganzflächige Beschichtung der Zelloberfläche mit dem Kontaktmetall durchgeführt werden, welche bei einer folgenden Behandlung mit Aceton in einem Lift-Off Schritt an all den Stellen entfernt wird, an denen sich noch Photolack befand. Je nach gewählten Beschichtungsverfahren kann eine Wärmebehandlung zum Eintempern der Kontakte angeschlossen werden. Abschließend werden die Metallfinger nach dem zuvor beschriebenen Herstellungsprozeß durch eine Hauptleiterbahn ("Busbar") verbunden. Hat man als Metallisierungsmethode das Plattieren gewählt, so kann dieser Vorgang in den Herstellungsprozeß der Kontaktfinger in 5 integriert werden. Hierfür belichtet man nach erfolgter schräger Bestrahlung des Photolackes bei nun senkrechtem Lichteinfall mit Hilfe einer Streifenmaske einen der Zellgröße entsprechend breiten Streifen des Photolackes orthogonal zur Richtung der Kontaktfinger 5.

Das vorgestellte Verfahren hat zum einen den Vorteil, daß sowohl das Auftragen des Photolackes einfach zu handhaben ist als auch der Belichtungsvorgang durch das Wegfallen der Justierung von photolithographischen Masken sehr erleichtert wird.

### Funktionsweise der erfindungsgemäßen Solarzelle:

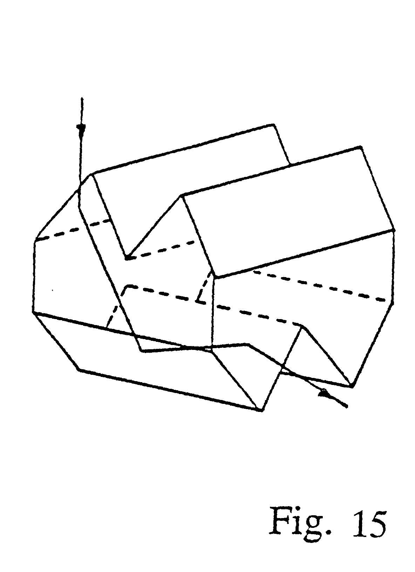

Fällt Licht auf die Solarzelle, so wird es durch das V-förmige Profil der Gräben 8 auf der Oberfläche der Solarzelle sehr effizient in diese eingekoppelt. Dies beruht sowohl auf Mehrfachreflexionen der einfallenden Strahlung an den Grabenwänden als auch auf einer Ablenkung des in die Solarzelle transmittierten Strahlungsanteils von der senkrechten Einfallsrichtung, wodurch dieser durch Unterschreitung des Grenzwinkels der Totalreflexion sehr wirksam im Innern der Solarzelle eingefangen wird (siehe hierzu Fig. 15).
Anhand von Fig. 15 wird der Strahlengang mit auf der Vorder- und Rückseite unter einem Winkel zueinander angeordneten V-Gräben veranschaulicht - wobei aus Gründen der Deutlichkeit die erfindungsgemäßen Löcher weggelassen sind. Im allgemeinen gilt, daß ein Strahl langwelligen Lichtes vom Solarzellenmaterial nur schlecht absorbiert und in einer konventionellen Solarzelle nach zweimaligen Durchlaufen der Zelldicke, bei Reflexion an der metallisierten (d.h. verspiegelten) Rückseite, an der Vorderseite wieder ausgekoppelt wird. Bei der hier vorgestellten Struktur wird der senkrecht zueinander angeordneten V-Gräben der eingekoppelte Lichtstrahl auf der Rückseite der Zelle aus der Einfallsebene ausgelenkt, wie schematisch dargestellt, trifft danach auf eine weitere Rückseitenfläche und legt somit einen relativ langen Weg in der Solarzelle zurück, was die Absorptionswahrscheinlichkeit und somit die Empfindlichkeit der Zelle im Infraroten wesentlich erhöht.
Optische Verluste treten zum einen bei senkrechtem Lichteinfall durch die bei der vorgestellten Struktur vorhandenen Löcher 7 auf, zum anderen in Ausführungsvariante I durch Reflexionsverluste an den Kontaktfingern 5. Bei einem Grabenabstand von 100µm mit 5µm (20µm) Lochkantenlange d beträgt der Anteil der von den Löchern 7 bedeckten Fläche 0,25% (4%). Die durch die Kontaktmetallisierung bei Ausführungsvariante I optisch unsensible Fläche läßt sich wie folgt abschatzen: Bei Annahme eines Kontaktstegabstandes a (Fig. 6) von 400µm und einer Stegbreite f von 10µm ergibt sich ein Verhältnis der mit Metall überzogenen Fläche zur Gesamtfläche von 2,5%. In Ausführungsvariante II treten an den Kontaktfingern 5 keine Einbußen an Lichtleistung auf, da die einfallende Strahlung dort direkt in den angrenzenden Graben 8 hineinreflektiert wird und zur Erzeugung elektrischer Leistung eingefangen werden kann. Aufgrund der vollständigen Anordnung der Kontaktfinger bei der Rückseiten-Solarzellenvariante von Ausführungsbeispiel III sind keine Beschattungsverluste aufgrund der Zellmetallisierung zu erwarten. Verkippt man die Flächennormale der Solarzelle zur Einfallsrichtung des senkrecht eingestrahlten Lichtes um mehr als die Hälfte des Grabenspitzenwinkels y parallel zur Richtung der dem Licht zugewandten Gräben 8, so ist der Lichtdurchgang durch die Löcher 7 im Grundkörper, der die teilweise optische Transparenz bewirkt, weitgehend unterbunden.
Aufgrund der relativ kleinen optischen Verluste in Kombination mit der für einen effizienten Lichteinfang günstigen Grabenstruktur wird es möglich, daß ein Großteil des einfallenden Sonnenlichtes im Wellenlängenbereich kleiner 1200nm durch die Solarzelle absorbiert wird. Dabei werden im Silizium Ladungsträger (Elektronen und Defektelektronen) generiert. Im p-dotierten Grundsubstrat 1, das den Hauptanteil des Volumens der Solarzelle ausfüllt, diffundieren die dort erzeugten Minoritätsladungsträger, Elektronen, zum Emitter 2. Aufgrund des günstigen geometrischen Zuschnittes der vorliegenden Zellenstruktur sowie der fast ganzflächigen Ausbildung des Emitters 2 müssen dabei Entfernungen R (Fig. 10) von weniger als z.B. 35µm überwunden werden. Bei gängigen Diffüsionslängen in multikristallinem Silizium von 40µm ist eine hohe Ausbeute bei der Einsammlung der generierten Ladungsträger zu erwarten. Eine weitere Eigenschaft der vorgestellten Solarzelle, die dies unterstützt, ist die fast ganzflächige Passivierung der Oberfläche mittels thermischem Siliziumoxid 3 und die damit verbundene Herabsetzung der Oberflächenrekombinationsgeschwindiekeit s. Ein kleiner Wert für s über fast das gesamte Äußere wirkt sich positiv in Hinblick auf eine hohe offene Klemmspannung der beleuchteten Zelle aus.
Die zur Emitterfläche gelangten Elektronen werden nun über die Metallfinger 5 , die sich über einer n⁺⁺-Dotierungszone 4 befinden, und die Hauptleiterbahn an einen äußeren Kreis abgeleitet. Dabei muß der Teil der Elektronen, welcher auf der der n⁺⁺-Kontaktzone gegenüberliegenden Zellenseite generiert wurde, durch die die beiden Seiten elektrisch verbindenden Löcher 7 fließen. Dies ähnelt einem Prinzip, das man bei der Polka-Dot-Solarzelle [9], die auf monokristallinem Silizium mit Hilfe photolithographischer Verfahren hergestellt wurde, anwandte.

### Bezugszeichen

- 1: Grundsubstrat
- 2: Emitter(schicht)
- 3: Oxidschicht
- 4: Dotierungszone
- 5: Kontaktfinger/ Kontaktbahn
- 6: Siliziumsteg
- 7: Löcher
- 8: Graben
- 9: n++Ädotierter Steg
- 10: p++Ädotierter Steg
- 11: Absaugöffnung (a); Absaugleitung (b)
- 12: gesägte Strukturen

### Referenzen

(1) R.F. Van Overstraeten, R.P. Mertens, Physics; Technology and Use of Photovoltaics, Adam Hilger, Bristol, 1986, Seiten 148-150
(2) M.A Green, High Efficiency Silicon Solar Cells, Trans Tech Publications, Kensington, 1987, Seiten 208-213
(3) A. Wang, J. Zhao, M.A. Green, Appl. Phys. Lett. 57 (6), 1990, Seiten 602-604
(4) J. Wohlgemuth, A. Scheinine, Proc. 14th IEEE PVSC, San Diego, 1980, Seiten 151-153
(5) J.S. Culik, E.L. Jackson, A.M. Barnett, Proc. 20th IEEE PVSC, Kissimimee, 1990, Seiten 251-256
(6) S. Narayanan, J. Zolper, F. Yun, S.R. Wenham, A.B. Sproul, C.M. Chong, M.A. Green, Proc. 20th IEEE PVSC, Kissimimee, 1990, Seiten 678-680
(7) T. Okuno, S. Moriuchi, K. Nakajimy, Y. Yokosawa, K. Okamoto, T. Nunoi, H. Sawai, Proc. 11th, EEC PVSEC, Montreux, 1992, Seiten 408ff
(8) G. Willeke, H. Nussbaumer, H. Bender, E. Bucher, Solar Energy Materials and Solar Cells 26, North-Holland, 1992, Seiten 345-356,
(9) R.N. Hall, T.J. Soltys, Proc. 14th IEEE PVSC, San Diego, 1980, pp. 550-553
(10) M.A. Green, High Efficiency Silicon Solar Cells, Trans Tech Publications, Kensington, 1987, Seiten 189-191, Seite 216
(11) M.A. Green, High Efficiency Silicon Solar Cells, Trans Tech Publications, Kensington, 1987, Seite 171

## Patentansprüche

1. Verfahren zur Herstellung einer Solarzelle mit pn-Ubergang, bestehend aus einem Grundkörper (1) aus kristallinem Silizium, in welchem durch einfallende Strahlungsgenergie Ladungsträger erzeugt werden, sowie aus elektrischen Kontakten (5, 10) zum Ableiten der Ladungsträger,
wobei in den Grundkörper (1) bestehend aus kristallinem Silizium mit einheitlicher Grunddotierung eine Vielzahl von Gräben (12, 13) auf der Vorder- und Rückseite des Grundkörpers (1) eingearbeitet und derart ausgerichtet und dimensioniert werden, daß sie auf beiden Seiten des Grundkörpers (1) relativ zueinander einen Winkel einschließen und jeweils so tief sind, daß an den Kreuzungspunkten der Gräben (12, 13) von Vorder- und Rückseite automatisch Durchgangslöcher (7) entstehen, wodurch ein Gitternetz gebildet wird, so daß eine lichtdurchlässige Solarzelle erhalten wird.

2. Verfahren nach Anspruch 1,
**dadurch gekennzeichnet,**
**daß** V-förmige Gräben (12, 13) eingearbeitet werden.

3. Verfahren nach einem der Ansprüche 1 bis 2,
**dadurch gekennzeichnet,**
**daß** die Gräben (12, 13) parallel zueinander eingearbeitet werden.

4. Verfahren nach Anspruch 1 oder 2 oder 3,
**dadurch gekennzeichnet,**
**daß** die Gräben (12, 13) äquidistant eingearbeitet werden.

5. Verfahren nach einem der Ansprüche 1 bis 4,
**dadurch gekennzeichnet,**
**daß** die Gräben (12, 13) mechanisch eingebracht werden.

6. Verfahren nach Anspruch 5,
**dadurch gekennzeichnet,**
**daß** die Gräben (12, 13) mittels eines schnell rotierenden, aus einem walzenförmigen Metallgrundkörper bestehenden, das Negativprofil der Gräben (12, 13) aufweisenden Sägeformkörpers eingebracht werden.

7. Verfahren nach Anspruch 6,
**dadurch gekennzeichnet,**
**daß** der Sägeformkörper mit einem Abriebmittel überzogen wird.

8. Verfahren nach einem der Ansprüche 1 bis 7,
**dadurch gekennzeichnet,**
**daß** die Gräben (12, 13) relativ zu den Außenseiten des Grundkörpers (1) jeweils so eingearbeitet werden, daß auf der Vorder- und/oder Rückseite des Grundkörpers (1) hervorstehende Kontaktstege zur Realisierung der elektrischen Kontakte (5, 10) entstehen.

9. Verfahren nach Anspruch 8, **dadurch gekennzeichnet, daß** die Kontaktstege metallisiert werden, und zur Ausbildung der Metallisierung ein walzenartiger Körper, der mit einer metallhaltigen Paste überzogen ist, über die Stege gerollt wird.

10. Verfahren nach Anspruch 8,
**dadurch gekennzeichnet,**
**daß** eine Dotierungszone ausgebildet wird und zur Ausbildung der Dotierungszone (4, 11) auf die Kontaktstege (6, 9) ein Ätzmittel zur selektiven Öffnung einer Passivierungschicht mittels eines walzenartigen Körpers aufgetragen wird.

11. Verfahren nach Anspruch 10,
**dadurch gekennzeichnet,**
**daß** eine dotandenhaltige Paste zur selektiven kontaktdiffusion mittels eines walzenartigen Körpers aufgetragen wird.

12. Verfahren nach einem der vorhergehenden Ansprüche,
**dadurch gekennzeichnet,**
**daß** der Emitter ganzflächig ausgeführt wird.

13. Verfahren nach einem der vorhergehenden Ansprüche,
**dadurch gekennzeichnet, daß** die Oberfläche der Solarzelle gauzflächig mit Ausnahme der Kontaktzonen, passiviert wird.

14. Solarzelle, umfassend einen Grundkörper (1) aus Silizium mit sperrendem pn-Übergang, in welchem durch einfallende Strahlungsenergie Ladungsträger erzeugbar sind, die trennbar und über elektrische Kontakte (5, 10) ableitbar sind und in welchem Durchgangslöcher vorgesehen sind,
**dadurch gekennzeichnet,**
**daß** der Grundkörper aus kristallinem Siliziumsubstrat mit einheitlicher Grunddotierung besteht, daß auf der Vorder- und Rückseite des Grundkörpers (1) Gräben (12, 13) eingearbeitet sind, und
**daß** die Gräben (12, 13) derart ausgerichtet und dimensioniert sind, daß sie auf beiden Seiten des Grundkörpers (1) relativ zueinander einen Winkel bilden und jeweils so tief sind, daß an den Kreuzungspunkten der Gräben (12, 13) von Vorder- und Rückseite automatisch Durchgangslöcher (7) und damit ein Gitternetz entstehen.

15. Solarzelle nach Anspruch 14,
**dadurch gekennzeichnet,**
**daß** die Gräben (12, 13) V-förmig ausgebildet sind.

16. Solarzelle nach einem der Ansprüche 14, 15,
**dadurch gekennzeichnet,**
**daß** die Gräben (12, 13) parallel zueinander eingearbeitet sind.

17. Solarzelle nach Anspruch 14 oder 15 oder 16,
**dadurch gekennzeichnet,**
**daß** die Gräben (12, 13) äquidistant zueinander eingearbeitet sind.

18. Solarzelle nach einem der Ansprüche 14 bis 17,
**dadurch gekennzeichnet,**
**daß** die Gräben (12, 13) relativ zu den Außenseiten des Grundkörpers (1) jeweils so eingearbeitet sind, daß auf der Vorder- und/oder Rückseite des Grundkörpers (1) jeweils hervorstehende Kontaktstege (6, 9), die mit einer Metallisierung überzogen sind, entstehen.

19. Solarzelle nach Anspruch 18,
**dadurch gekennzeichnet,**
**daß** die Vorder- und Rückseite mit Ausnahme der Kontaktstege (6, 9) eine ganzflächige ausgebildete Emitterschicht (2, 8) aufweisen, und
**daß** die Emitterschicht der Vorderseite (2) mit der Emitterschicht der Rückseite (8) über die Durchgangslöcher (7) verbunden ist.

20. Solarzelle nach Anspruch 18 oder 19,
**dadurch gekennzeichnet,**
**daß** die Oberfläche ganzflächig mit Ausnahme der Kontaktzonen (6, 9) mit einer passivierenden Schicht (3) belegt ist.

21. Solarzelle nach Anspruch 18, 19 oder 20,
wobei herausragende Kontaktstege (6, 9) nur auf einer Seite ausgebildet sind,
**dadurch gekennzeichnet,**
**daß** die Kontaktstege (6, 9) in alternierender Reihenfolge mit einer n++-, beziehungsweise p++-Diffusion versehen sind.

## Claims

1. Process for producing a solar cell having pn junction, comprising a base body (1) of crystalline silicon, in which charge carriers are produced by incident radiation energy, and electrical contacts (5, 10) for shunting off the charge carriers, wherein a plurality of grooves (12, 13) are incorporated into the base body (1) consisting of crystalline silicon having uniform basic doping on the front and rear side of the base body (1), and are aligned and have dimensions such that they enclose an angle on both sides of the base body (1) relative to one another and are in each case so deep that through-holes (7) automatically result at the intersections of the grooves (12, 13) of front and rear side, resulting in a grid network being formed, so that a light-permeable solar cell is obtained

2. Process according to claim 1, **characterised in that** V-shaped grooves (12, 13) are incorporated

3. Process according to one of claims 1 to 2, **characterised in that** the grooves (12, 13) are incorporated parallel to one another

4. Process according to claim 1 or 2 or 3, **characterised in that** the grooves (12, 13) are incorporated equidistantly.

5. Process according to one of claims 1 to 4, **characterised in that** the grooves (12, 13) are introduced mechanically

6. Process according to claim 5, **characterised in that** the grooves (12, 13) are introduced by means of a rapidly rotating saw body consisting of a roller-like metal base body and having the negative profile of the grooves (12, 13)

7. Process according to claim 6, **characterised in that** the saw body is covered with an abrasive

8. Process according to one of claims 1 to 7, **characterised in that** grooves (12, 13) are incorporated relatively to the outer sides of the base body (1) in each case so that projecting contact bars are produced on the front and/or rear side of the base body (1) to realise the electrical contacts (5, 10).

9. Process according to claim 8, **characterised in that** the contact bars are metallised, and to effect the metallisation, a roller-like body, which is covered with a metal-containing paste, is rolled over the bars.

10. Process according to claim 8, a doping zone is formed and to form the doping zone (4, 11) on the contact bars (6, 9), an etching agent is applied for selective opening of a passivating layer by means of a roller-like body

11. Process according to claim 10, **characterised in that** a paste containing doping agent is applied by means of a roller-like body for selective contact diffusion.

12. Process according to one of the preceding claims, **characterised in that** the emitter is designed to be over the entire surface

13. Process according to one of the preceding claims, **characterised in that** the surface of the solar cell is made passive over the entire surface with the exception of the contact zones

14. Solar cell comprising a base body (1) of silicon having blocking pn junction, in which charge carriers can be produced by incident radiation energy and can be separated and shunted off via electrical contacts (5, 10), and in which through-holes are provided, **characterised in that** the base body consists of crystalline silicon substrate having uniform basic doping, **in that** grooves (12, 13) are incorporated on the front and rear side of the base body (1), and **in that** the grooves (12, 13) are aligned and have dimensions such that they form an angle on both sides of the base body (1) relative to one another and are in each case so deep that through-holes (7) automatically result at the intersections of the grooves (12, 13) of front and rear side and hence a grid network

15. Solar cell according to claim 14, **characterised in that** the grooves (12, 13) are designed to be V-shaped.

16. Solar cell according to one of claims 14,15, **characterised in that** the grooves (12, 13) are incorporated parallel to one another.

17. Solar cell according to claim 14 or 15 or 16, **characterised in that** the grooves (12, 13) are incorporated equidistantly to one another

18. Solar cell according to one of claims 14 to 17, **characterised in that** the grooves (12, 13) are incorporated relatively to the outer sides of the base body (1) in each case so that in each case projecting contact bars (6, 9), which are covered with metallisation, result on the front and/or rear side of the base body (1)

19. Solar cell according to claim 18, **characterised in that** the front and rear side have an emitter layer (2, 8) designed to be over the entire surface with the exception of the contact bars (6, 9), and **in that** the emitter layer of the front side (2) is connected to the eminer layer of the rear side (8) via the through-holes (7).

20. Solar cell according to claim 18 or 19, **characterised in that** the surface is covered with a passivating layer (3) over the entire surface with the exception of the contact zones (6, 9)

21. Solar cell according to claim 18, 19 or 20, wherein projecting contact bars (6, 9) are designed only on one side, **characterised in that** the contact bars (6, 9) are provided in alternating sequence with n++, or p++ diffusion.

## Revendications

1. Procédé pour fabriquer une cellule solaire avec transition PN, composée d'un corps de base (1) en silice cristallin, dans lequel des porteurs de charge sont créés par énergie rayonnante incidente, ainsi que de contacts électriques (5, 10) pour dériver les porteurs de charge, de nombreuses rigoles (12, 13) étant ménagées dans le corps de base (1) composé de silice cristallin avec un dopage de base uniforme sur le côté avant et le côté arrière du corps de base (1) et étant orientées et dimensionnées de telle sorte qu'elles forment un angle sur les deux côtés du corps de base (1) l'une par rapport à l'autre et qu'elles sont respectivement si profondes que des trous de passage (7) sont créés automatiquement aux points de croisement des rigoles (12, 13) du côté avant et du côté arrière, un réseau de quadrillage étant ainsi formé, de sorte qu'on obtient une cellule solaire transparente.

2. Procédé selon la revendication 1, **caractérisé en ce que** sont ménagées des rigoles en forme de V (12, 13).

3. Procédé selon l'une des revendications 1 à 2, **caractérisé en ce que** les rigoles (12, 13) sont ménagées parallèlement les unes aux autres.

4. Procédé selon la revendication 1 ou 2 ou 3, **caractérisé en ce que** les rigoles (12, 13) sont ménagées à équidistance.

5. Procédé selon l'une des revendications 1 à 4, **caractérisé en ce que** les rigoles (12, 13) sont réalisées mécaniquement.

6. Procédé selon la revendication 5, **caractérisé en ce que** les rigoles (12, 13) sont réalisées à l'aide d'un corps en forme de scie tournant rapidement, composé d'un corps de base métallique en forme de rouleau et présentant le profil négatif des rigoles (12,13).

7. Procédé selon la revendication 6, **caractérisé en ce que** le corps en forme de scie est recouvert d'un moyen abrasif.

8. Procédé selon l'une des revendications 1 à 7, **caractérisé en ce que** les rigoles (12, 13) sont respectivement ménagées par rapport aux côtés extérieurs du corps de base (1) de telle sorte qu'on obtient des nervures de contact dépassant sur le côté avant et/ou le côté arrière du corps de base (1) pour la réalisation des contacts électriques (5, 10).

9. Procédé selon la revendication 8, **caractérisé en ce que** les nervures de contact sont métallisées, et que pour la formation de la métallisation un corps en forme de rouleau, recouvert d'une pâte métallique, est roulé sur la tige.

10. Procédé selon la revendication 8, **caractérisé en ce qu'**une zone de dopage est formée et qu'une solution caustique pour l'ouverture sélective d'une couche de passivation au moyen d'un corps en forme de rouleau est appliqué pour la formation de la zone de dopage (4, 11) sur les nervures de contact (6, 9).

11. Procédé selon la revendication 10, **caractérisé en ce qu'**une pâte contenant un dopant est appliquée au moyen d'un corps en forme de rouleau pour un transfert par diffusion sélectif.

12. Procédé selon l'une des revendications précédentes, **caractérisé en ce que** l'émetteur est dirigé sur toute la surface.

13. Procédé selon l'une des revendications précédentes, **caractérisé en ce que** la surface supérieure de la cellule solaire est passivée sur toute la surface à l'exception des zones de contact.

14. Cellule solaire, comprenant un corps de base (1) en silice avec transition PN obstruante, dans lequel des porteurs de charge peuvent être créés grâce à une énergie rayonnante incidente, ces porteurs de charge pouvant être séparés et dérivés à l'aide de contacts électriques (5, 10) et dans lequel corps des trous de passage sont prévus, **caractérisée en ce que** le corps de base est composé de substrat de silice cristallin avec un dopage de base uniforme, **en ce que** des rigoles (12, 13) sont ménagées sur le côté avant et le côté arrière du corps de base (1), et **en ce que** les rigoles (12, 13) sont orientées et dimensionnées de telle sorte qu'elles forment un angle sur les deux côtés du corps de base (1) l'une par rapport à l'autre et qu'elles sont si profondes que des trous de passage (7) sont automatiquement créés aux points de croisement des rigoles (12, 13) du côté avant et du côté arrière, et qu'on obtient ainsi un réseau de quadrillage.

15. Cellule solaire selon la revendication 14, **caractérisée en ce que** les rigoles (12, 13) sont en forme de V.

16. Cellule solaire selon l'une des revendications 14, 15, **caractérisée en ce que** les rigoles (12, 13) sont ménagées de façon parallèle l'une à l'autre.

17. Cellule solaire selon la revendication 14 ou 15 ou 16, **caractérisée en ce que** les rigoles (12, 13) sont ménagées à équidistance.

18. Cellule solaire selon l'une des revendications 14 à 17, **caractérisée en ce que** les rigoles (12, 13) sont ménagées par rapport aux côtés extérieurs du corps de base (1) de telle sorte que des nervures de contact (6, 9) saillant respectivement sur le côté avant ou le côté arrière du corps de base (1) et recouvertes d'une métallisation sont créées.

19. Cellule solaire selon la revendication 18, **caractérisée en ce que** le côté avant et le côté arrière, à l'exception des nervures de contact (6, 9), présentent une couche émettrice (2, 8) formée sur toute la surface et **en ce que** la couche émettrice du côté avant (2) est raccordée à la couche émettrice du côté arrière (8) par l'intermédiaire des trous de passage (7).

20. Cellule solaire selon la revendication 18 ou 19, **caractérisée en ce que** la surface est recouverte d'une couche passivante (3) sur toute la surface, à l'exception des zones de contact (6, 9).

21. Cellule solaire selon la revendication 18, 19 ou 20, des nervures de contact saillantes (6, 9) n'étant formées que sur un seul côté, **caractérisée en ce que** les nervures de contact (6, 9) sont alternativement munies d'une diffusion n++-, ou p++-.
